(19) Europäisches Patentamt
European Patent Office
Office européen des brevets

(11) **EP 3 729 533 B1**

(12) **EUROPEAN PATENT SPECIFICATION**

(45) Date of publication and mention of the grant of the patent:
**23.10.2024 Bulletin 2024/43**

(21) Application number: **18845315.3**

(22) Date of filing: **18.12.2018**

(51) International Patent Classification (IPC):
**H10K 30/30** *(2023.01)*

(52) Cooperative Patent Classification (CPC):
**H10K 30/30; H10K 30/57;** H10K 85/113;
H10K 85/655; H10K 85/6576; Y02E 10/549

(86) International application number:
**PCT/IB2018/060276**

(87) International publication number:
**WO 2019/123267 (27.06.2019 Gazette 2019/26)**

(54) **ACTIVE LAYERS AND OPTOELECTRONIC DEVICES BASED ON NON-FULLERENES AND/OR HOLE SCAVENGERS**

AKTIVE SCHICHTEN UND OPTOELEKTRONISCHE VORRICHTUNGEN AUF DER GRUNDLAGE VON NICHT-FULLERENEN UND/ODER LOCH-SCAVENGERN

COUCHES ACTIVES ET DISPOSITIFS OPTOÉLECTRONIQUES À BASE DE NON FULLERÈNES ET/OU DE CAPTEURS DE TROUS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2017 US 201762607058 P**
**23.03.2018 US 201862646975 P**

(43) Date of publication of application:
**28.10.2020 Bulletin 2020/44**

(73) Proprietor: **King Abdullah University Of Science And Technology**
**Thuwal 23955 (SA)**

(72) Inventors:
• **BARAN, Derya**
**Thuwal, 23955-6900 (SA)**
• **GASPARINI, Nicola**
**Thuwal, 23955-6900 (SA)**
• **BRYANT, Daniel Thomas James**
**Thuwal, 23955-6900 (SA)**
• **TROUGHTON, Joel**
**Thuwal, 23955-6900 (SA)**

(74) Representative: **Ipsilon**
**Le Centralis**
**63, avenue du Général Leclerc**
**92340 Bourg-la-Reine (FR)**

(56) References cited:
**WO-A1-02/101838**

• **HUIFENG YAO ET AL: "Design, Synthesis, and Photovoltaic Characterization of a Small Molecular Acceptor with an Ultra-Narrow Band Gap", ANGEWANDTE CHEMIE, INTERNATIONAL EDITION, vol. 56, no. 11, 1 February 2017 (2017-02-01), DE, pages 3045 - 3049, XP055511236, ISSN: 1433-7851, DOI: 10.1002/anie.201610944**

• **HUIFENG YAO ET AL: "Design, Synthesis, and Photovoltaic Characterization of a Small Molecular Acceptor with an Ultra-Narrow Band Gap; Supporting Information", ANGEWANDTE CHEMIE INTERNATIONAL EDITION, vol. 56, 1 February 2017 (2017-02-01), pages 3045 - 1, XP055581173, DOI: 10.1002/anie.201610944**

• **SARAH HOLLIDAY ET AL: "High-efficiency and air-stable P3HT-based polymer solar cells with a new non-fullerene acceptor", NATURE COMMUNICATIONS, vol. 7, no. 1, 9 June 2016 (2016-06-09), XP055581268, DOI: 10.1038/ncomms11585**

**Description**

**BACKGROUND**

Organic semiconductors are envisioned to positively impact human life through applications ranging from sensors and displays to lighting and photovoltaics. As opposed to most inorganic counterparts, organic devices can be printed from solution on plastic substrates, allowing for extremely thin, lightweight and elastic products that can be manufactured over large areas with freedom of shape. In the last decade, organic photovoltaics (OPV), ferried by the impressive improvement in device efficiency and stability, started out to gradually move from a mere phenomenon in the lab to a niche market. One key advantage of solution-processable organic semiconductors is the opportunity of blending different materials in order to attain novel material properties and applications.

An intriguing approach for OPV development is to shift the absorption window of the active layer material from the visible (400-700 nm) to the near-infrared (NIR) part of the spectrum to fabricate semitransparent organic solar cells featuring transparency in the visible range, while simultaneously harvesting the infrared part of the spectrum for the light-to-current conversion. Commonly fullerene derivatives, e.g. PCBM and $PC_{70}BM$, were the common acceptor materials. When used in combination with the donor small molecules or polymers, they formed the photoactive layer of bulk heterojunction (BHJ) solar cells. The recent fast pace of OPV development upon the advent of highly efficient alternatives to fullerenes, so called non-fullerene electron (NF) materials with superior light harvesting, stability and charge recombination behavior over fullerene-based devices is expected to be of particular relevance. The photoactive layer of a bulk-heterojunction solar cells consists of donor and acceptor materials intimately mixed together in order to maximize the light-to-current conversion. Thus, the common donor/acceptor (D/A) is 1:1-1:2 by weight (w/w) and rarely more than 1:4 w/w can be found in the literature. Having similar amounts of the two components improves i) the exciton quenching, since the D/A interfaces are distributed throughout the bulk and, at the same time, ii) the formation of percolation pathways for the carriers to their respective electrodes. Notably, by considering the average visible transmission (AVT) of the photoactive layer with 1:1-1:4 w/w D/A, very few examples are reporting AVT >50% and on the same time preserving power conversion efficiency (PCE) >5%. The common procedure to increase the AVT in fullerene and NF-based system is to decrease the photoactive layer thickness and shifting the absorption in the NIR region. NFs offer higher chances for higher AVT over fullerene derivatives, due to the absorption of $PC_{70}BM$ in the visible region, whereas NF can be designed to absorb above 700 nm. HUIFENG YAO ET AL, see "Design, Synthesis, and Photovoltaic Characterization of a Small Molecular Acceptor with an Ultra-Narrow Band Gap", ANGEWANDTE CHEMIE, INTERNATIONAL EDITION, vol. 56, no. 11, 1 February 2017 (2017-02-01), pages 3045-3049 describe an organic optoelectronic device comprising two electrodes and an active layer, said active layer comprising a donor and a non-fullerene acceptor.

**SUMMARY**

In general, embodiments of the present disclosure describe active layers of optoelectronic devices, methods of fabricating active layers, optoelectronic devices including active layers, methods of fabricating optoelectronic devices, tandem solar cells, and methods of converting light to current.

Accordingly, embodiments of the present disclosure describe an active layer of an optoelectronic device comprising a non-fullerene component and optionally one or more hole-scavenging components. In an embodiment, an active layer of an optoelectronic device comprises a non-fullerene component. In an embodiment, an active layer of an optoelectronic device consists essentially of a non-fullerene component. In an embodiment, an active layer of an optoelectronic device comprises a non-fullerene component and a hole-scavenging component. In an embodiment, an optoelectronic device consists essentially of a non-fullerene component and a hole-scavenging component.

Embodiments of the present disclosure describe a method of fabricating an active layer of an optoelectronic device comprising contacting a non-fullerene component and optionally one or more hole-scavenging components in a presence of a solvent sufficient to form an active layer of an optoelectronic device. In an embodiment, the method further comprises depositing the blended solution on one or more of a substrate, selective contact layer, and electrode material.

Embodiments of the present disclosure describe an optoelectronic device comprising a first electrode material; an active layer; and a second electrode material, wherein the first electrode material and the second electrode material are on opposing sides of the active layer. In an embodiment, the active layer consists essentially of a non-fullerene component, or comprises a non-fullerene component and one or more hole-scavenging components. In an embodiment, the optoelectronic device may optionally include one or more of a substrate, a first selective contact layer, and a second selective layer.

Embodiments of the present disclosure describe an optoelectronic device comprising one or more of a substrate, a first electrode material, a first selective contact layer, an active layer, a second selective contact layer, and a second electrode material. In an embodiment, one or more of the substrate, the first selective contact layer, and the second selective contact layer are optionally included in the optoelectronic device.

Embodiments of the present disclosure describe a tandem solar cell comprising a substrate; an organic photovoltaic (OPV) subcell including at least an active layer, wherein the active layer comprises a non-fullerene component and one or more hole-scavenging components; and an amorphous silicon (a-Si) subcell including at least a layer of amorphous silicon; wherein the OPV subcell and the substrate are on opposing sides of the a-Si subcell.

Embodiments of the present disclosure describe a method of fabricating an optoelectronic device comprising depositing a blended solution on a first material sufficient to form an active layer, wherein the blended solution includes a non-fullerene component and one or more hole-scavenging components; and depositing a second material on the active layer, wherein the first material and the second material are on opposing sides of the active layer.

Embodiments of the present disclosure describe a method of using an optoelectronic device comprising irradiating an active layer of an optoelectronic device, wherein the active layer comprises a non-fullerene component and optionally one or more hole-scavenging components, and converting light to electricity or electricity to light.

The details of one or more examples are set forth in the description below. Other features, objects, and advantages will be apparent from the description and from the claims.

## BRIEF DESCRIPTION OF DRAWINGS

This written disclosure describes illustrative embodiments that are nonlimiting and non-exhaustive. In the drawings, which are not necessarily drawn to scale, like numerals describe substantially similar components throughout the several views. Like numerals having different letter suffixes represent different instances of substantially similar components. The drawings illustrate generally, by way of example, but not by way of limitation, various embodiments discussed in the present document.

Reference is made to illustrative embodiments that are depicted in the figures, in which:

FIG. **1** is a flowchart of a method of a method of fabricating an active layer of an optoelectronic device, according to one or more embodiments of the present disclosure.

FIG. **2** is a schematic diagram of an optoelectronic device, according to one or more embodiments of the present disclosure.

FIG. **3** is a schematic diagram of an optoelectronic device showing various optional layers of an optoelectronic device, according to one or more embodiments of the present disclosure.

FIG. **4** is a flowchart of a method of fabricating an optoelectronic device, according to one or more embodiments of the present disclosure.

FIG. **5** is a flowchart of a method of using an optoelectronic device comprising an active layer of the present disclosure, according to one or more embodiments of the present disclosure.

FIG. **6** is a schematic diagram showing a configuration of an inverted organic solar cell, according to one or more embodiments of the present disclosure.

FIG. **7** is a schematic diagram of a chemical formula for donor/acceptor materials used as a photoactive layer, according to one or more embodiments of the present disclosure.

FIG. **8** is a graphical view showing J-V characteristics of a single component photoactive layer comprising a non-fullerene component, according to one or more embodiments of the present disclosure.

FIG. **9** is a graphical view of a diluted system comprising a ratio of the hole-scavenging component to non-fullerene component of 1:10, according to one or more embodiments of the present disclosure.

FIG. **10** is a graphical view of UV-Vis plots of diluted PTB7-th:IEICO-4F blend in comparison with human eye sensitivity for AVT, according to one or more embodiments of the present disclosure.

FIG. **11** is a graphical view of UV-Vis plots of diluted PTB7-th:IEICO-4F blend in comparison with human eye sensitivity for transparency, according to one or more embodiments of the present disclosure.

FIG. **12** is an optical micrographs of a solar module with three interconnected sub-cells, where the insets on the left represent optical magnifications of the interconnection region, where the laser lines P1, P2, and P3 are highlighted, and where the photo-inactive area (dead area, blue) and total area (yellow) of the module are highlighted as well, according to one or more embodiments of the present disclosure.

FIG. **13** is a graphical view of normalized PCE of 1:2 and 1:10 D/A based solar cells in the course of light exposure, according to one or more embodiments of the present disclosure.

FIGS. **14A-14B** are graphical views showing (A) current-voltage characteristics of binary and ternary devices at 1 sun illumination; and (B) normalized PCE as a function of time for binary and ternary devices degraded at 80 degrees C in inert conditions, according to one or more embodiments of the present disclosure.

FIG. **15** is a graphical view showing current-voltage response and statistics for single and multi-junction solar cells based on the diluted organic system, according to one or more embodiments of the present disclosure.

FIG. **16** is a schematic drawing of a tandem solar cell, according to one or more embodiments of the present disclosure.

## DETAILED DESCRIPTION

The invention of the present disclosure relates to active layers as defined in the appended claims that may be incorporated into a variety of optoelectronic devices. For example, the active layers may be incorporated into, among other things, one or more of solar cells, photodetectors, paraelectric devices, field-effect transistors, photodiodes, phototransistors, photomultipliers, optoisolators, integrated optical circuits, photoresistors, photoconductive tubes, charge-coupled devices, injection laser diodes, quantum cascade lasers, light-emitting diodes, organic light-emitting diodes, and photoemissive tubes. The active layers of the optoelectronic devices may comprise one or more of a non-fullerene component and a hole-scavenging component. Unlike conventional materials like fullerene acceptors, which were limited to absorbing UV radiation or near UV radiation, the non-fullerene component may absorb near-infrared radiation, among others, and thus may be used as transparent single-component optoelectronic devices. The non-fullerene component may be blended (e.g., intimately mixed) with one or more hole-scavenging components to form diluted systems. The active layers of the present disclosure may be used to scale-up and fabricate optoelectronic devices using with unprecedented transparency, stability, and performance characteristics. Another benefit is that the optoelectronic devices and/or active layers may be fabricated using a variety of coating and printing techniques using environmental friendly or green chemistry solvents.

While conventional active layers comprise donors and acceptors, the active layers of the present disclosure may comprise one or more non-fullerene components and optionally one or more hole-scavenging components. For example, the active layers of the present disclosure may consist essentially of one or more non-fullerene components (e.g., a non-fullerene electron acceptor), or may comprise one or more non-fullerene components and one or more hole-scavenging components. At least one benefit of the present invention is that electron hole / charge generation may be obtained in a single material (e.g., a non-fullerene material). In many embodiments, no donor material is required or included in the active layers of the present disclosure. For example, active layers and/or optoelectronic devices of the present disclosure may comprise or consist essentially of a non-fullerene component. In other embodiments, the active layer may further comprise one or more hole-scavenging components. For example, in some embodiments, the hole-scavenging component may not properly be considered a donor material because it may not function as and/or may not exhibit any of the characteristics of a donor. Rather, a low amount of hole-scavenging component may be introduced into the active layer to form a dilute system in which the hole scavenging component acts only as a hole scavenger and/or promotes the extraction of charges (e.g., extract a hole from non-fullerene acceptor).

The active layers and/or optoelectronic devices of the present disclosure exhibit unprecedented transparency and stability. In general, the non-fullerene component is substantially or completely transparent, while in some embodiments the hole-scavenging component may diminish transparency. Accordingly, in embodiments in which one or more hole-scavenging components are added, it may be desirable to add a low amount of the one or more hole-scavenging components in order to fabricate highly or completely transparent active layers and/or optoelectronic devices. These diluted systems comprising a relatively low concentration of hole-scavenging component may be highly stable.

Definitions

The terms recited below have been defined as described below. All other terms and phrases in this disclosure shall be construed according to their ordinary meaning as understood by one of skill in the art.

As used herein, "hole scavenger" or "hole scavenger component" or "hole scavenging component" refers to an element, compound, molecule, or material that promotes an extraction of charges.

As used herein, "non-fullerene" or "NF" or "non-fullerene component" refers to any material suitable for absorbing radiation.

As used herein, "contacting" refers to the act of touching, making contact, or of bringing to immediate or close proximity, including at the cellular or molecular level, for example, to bring about a physiological reaction, a chemical reaction, or a physical change, e.g., in a solution, in a reaction mixture, in vitro, or in vivo. Accordingly, adding, stirring, treating, tumbling, vibrating, shaking, mixing, and applying are forms of contacting to bring two or more components together.

As used herein, "depositing" refers to disposing, printing (e.g., ink-jet printing), doctor-blade coating, bar coating, slot-die coating, spray coating, growing, etching, doping, epitaxy, thermal oxidation, sputtering, casting, depositing (e.g., chemical vapor deposition, physical vapor deposition, etc.), spin-coating, evaporating, applying, treating, and any other technique and/or method known to a person skilled in the art.

As used herein, "irradiating" refers to exposing to radiation. The radiation may comprise any wavelength, frequency, or range thereof on an electromagnetic spectrum. For example, irradiating may refer to exposing to a near-infrared radiation.

As used herein, "converting" refers to any process for converting energy.

Embodiments of the present disclosure describe an active layer of an optoelectronic device comprising one or more non-fullerene components and optionally one or more hole-scavenging components. Embodiments of the present disclosure also describe an active layer of an optoelectronic device consisting essentially of a non-fullerene component, or comprising a non-fullerene component and one or more hole-scavenging components. In an embodiment, an active layer of an optoelectronic device consists essentially of a non-fullerene component. In an embodiment, an active layer of an optoelectronic device comprises a non-fullerene component. In an embodiment, an active layer of an optoelectronic device comprises a non-fullerene component and one or more hole-scavenging components. In an embodiment, an active layer of an optoelectronic device consists essentially of a non-fullerene component and one or more hole-scavenging components. In an embodiment, an active layer of an optoelectronic device comprises or consists essentially of a first non-fullerene component, a second non-fullerene component different from the first non-fullerene component, and a hole-scavenging component.

The optoelectronic device may generally include and/or refer to any device and/or system that sources, detects, and/or controls light. For example, the optoelectronic device may include any device based on one or more of photoelectric effect, photovoltaic effect, photoconductivity, stimulated emission, and radiative recombination. In many embodiments, the optoelectronic device uses organic electronics. For example, the optoelectronic device may include one or more of an organic photovoltaic (OPV), organic photodiode (OPD), organic light emitting diode (OLED), and organic photo field effect transistor (photOFET). In other embodiments, the optoelectronic device may include one or more of solar cells, photodetectors, paraelectric devices, field-effect transistors, photodiodes, phototransistors, photomultipliers, optoisolators, integrated optical circuits, photoresistors, photoconductive tubes, charge-coupled devices, injection laser diodes, quantum cascade lasers, light-emitting diodes, organic light-emitting diodes, and photoemissive tubes.

The active layer may be suitable for converting light to electricity and/or electricity to light. For example, in many embodiments, the active layer may be characterized as a photoactive layer. The active layer may absorb light from any portion of the electromagnetic spectrum. In many embodiments, the active layer absorbs near-infrared radiation. In other embodiments, the active layer absorbs one or more of visible, near-infrared, and infrared radiation.

The active layer may comprise a non-fullerene component (e.g., a non-fullerene acceptor or a non-fullerene electron acceptor). The non-fullerene component may include any non-fullerene material suitable for absorbing electromagnetic radiation or light of a desired wavelength, frequency, or range thereof. For example, the non-fullerene component may include any light-absorbing semiconductor material. In many embodiments, the non-fullerene component is a material that absorbs near-infrared radiation. The non-fullerene component may exhibit intrinsic semiconductor properties rather than excitonic properties. This feature of the non-fullerene component is completely different from conventional donor- and fullerene-based materials. For example, unlike conventional donors and acceptors, which solely give rise to excitons, the non-fullerene component may generate or form free charges. More specifically, the non-fullerene component may be able to efficiently split the excitons into free charges at about room temperature, among other temperatures, in the absence of any donor materials. In some embodiments, the non-fullerene component is ambipolar (e.g., generate free charges). For example, in an embodiment, due to the ambipolar character of the non-fullerene materials, each respective electrode may collect holes and electrons. While the non-fullerene materials may be ambipolar, this shall not be limiting because in other embodiments, the non-fullerene component may be or include materials that are not ambipolar.

The non-fullerene component may be one or more of a small molecule, oligomer, polymer, and cross-linked metastructure. In many embodiments, the non-fullerene component may include one or more of rhodanine-benzothiadiazole-coupled indacenodithiophene (IDTBR); indacenodithieno[3,2-b]thiophene, IT), end-capped with 2-(3-oxo-2,3-dihydroinden-1-ylidene)malononitrile (INCN) groups (ITIC); indaceno[1,2-b:5,6-b']dithiophene and 2-(3-oxo-2,3-dihydroinden-1-ylidene)malononitrile (IEIC); 2,2'-((2Z,2'Z)-((5,5'-(4,4,9,9-tetrakis(4-hexylphenyl)-4,9-dihydro-s-indaceno[1,2-b:5,6-b']dithiophene-2,7-diyl)bis(4-((2-ethylhexyl)- oxy)thiophene-5,2-diyl))bis(methanylylidene))bis(3-oxo-2,3-di- hydro-1H-indene-2,1-diylidene))dimalononitrile (IEICO); naphthalene diimide (NDI); bay-linked perylene bisimide (di-PBI); perylene bisimide (PBI); Benzotriazole-Containing End-Capped with Thiazolidine-2,4-dione (TD); Naphthalocyanine (NC); Phthalocyanine (PC); Naphtho[1,2-c :5,6- c ']bis[1,2,5]thiadiazole; (2E,2'E)-3,3'-(2,5-dimethoxy-1,4-phenylene)bis(2-(5-(4-(N-(2-ethylhexyl)-1,8-naphthalimide)yl)thiophen-2-yl)acrylonitrile) (NIDCS-MO); thieno[3,4-b] thiophene and 2-(1,1-dicyanomethylene)rhodanine combination (ATT-1); (3,9-bis(4-(1,1-dicyanomethylene)- 3-methylene-2-oxo-cyclopenta[b]thiophen)-5,5,11,11-tetrakis(4-hexylphenyl)-dithieno[2,3-d':2,3-d']-s-indaceno[1,2-b:5,6- b']-dithiophene (ITCC); Indanedione; Dicyannovinyl; Benzothiadiazole; Diketopyrolopyrrole; arylene diimide; and IDIC. In preferred embodiments, the non-fullerene component includes one or more of indacenodithiophene, indacenodithieno[3,2-b]thiophene, and indaceno[1,2-b:5,6-b']dithiophene.

While the one or more non-fullerene components by themselves are sufficient for the active layers (e.g., photoactive layers) of the optoelectronic devices of the present disclosure, in some embodiments, for example, a single component device (e.g., active layers consisting essentially of or comprising a non-fullerene component, etc.) may exhibit limited power conversion efficiency (PCE), which may be attributed to the non-ohmic contact of the HOMO/LUMO level with the HTL and ETL, respectively, and/or charge recombination processes in the material due to defects and/or trap states formation. To reduce this limitation, in some embodiments, a low amount of one or more materials may be introduced to form binary diluted systems, ternary diluted systems, etc. In such diluted systems, the "donor" material (e.g., polymer, small molecule, etc.) acts as a "hole scavenger," promoting the extraction of charges and improving, among other things, FF and $J_{sc}$ compared to the single component devices. Accordingly, because the "donor" material does not function, perform, act, or serve as a conventional "donor material" as understood by persons skilled in the art, this material is hereinafter referred to as a "hole scavenger" or a "hole scavenger component" or a "hole scavenging component."

Accordingly, in an embodiment, the active layer (e.g., photoactive layer) may further comprise one or more hole-scavenging components. For example, in an embodiment, an active layer of an optoelectronic device includes a non-fullerene component and a hole-scavenging component. This is an example of a binary diluted system. In another embodiment, an active layer of an optoelectronic device includes a non-fullerene component and one or more hole-scavenging components, wherein the one or more hole-scavenging components comprise a first hole-scavenging component and a second hole-scavenging component, wherein the first hole-scavenging component and the second hole-scavenging component are different. This is an example of a ternary diluted system. In an embodiment, an active layer of an optoelectronic device includes a first non-fullerene component, a second non-fullerene component different from the first non-fullerene component, and a hole-scavenging component. Higher order and/or different versions of diluted systems can be employed. In many embodiments, the active layer is a blend (e.g., mixture) of the one or more non-fullerene components and the one or more hole-scavenging components. The hole scavenging components may be one or more of a small molecule, oligomer, polymer, and cross-linked metastructure. The hole scavenging components may include one or more of thiophene, acene, fluorine, carbazole, indacenodithieno thiophene, indacenothieno thiphene, benzodithiazole, thieny-benzodithiophene-dione, benzotriazole, and diketopyrrolopyrrole.

In embodiments in which the active layer comprises one or more non-fullerene components and one or more hole-scavenging components, the active layer may be transparent or substantially transparent. In many embodiments, the non-fullerene component affords the transparency of the active layer, whereas the hole-scavenging component(s) may diminish the transparency of the active layer. In other words, as the amount of the hole scavenging component(s) increases, the transparency of the active layer decreases. Accordingly, many embodiments relate to a dilute system in which the amount of the one or more hole-scavenging components present in the active layer is low relative to the amount of the non-fullerene component.

A ratio of the one or more hole-scavenging components to the one or more non-fullerene components may be selected to adjust, modify, or enhance a PCE and/or transparency of the active layer. In many embodiments, the one or more non-fullerene components is an equal component, majority component, or the only component. For example, a ratio of the one or more hole-scavenging components to the one or more non-fullerene components ranges from 1:10 to 1:25.

The one or more non-fullerene components and the one or more hole-scavenging components are blended or mixed to form the active layer. A thickness of the active layer may be on a length scale ranging from nanometers to centimeters. For example, in an embodiment, a thickness of the active layer may range from about 1 nm to about 10 cm. In an embodiment a thickness of the active layer may range from about 1 nm to about 500 $\mu$m. In an embodiment, a thickness of the active layer may range from about 1 nm to about 1000 nm. In other embodiments, a thickness of the active layer may be less than about 1 nm. Depositing or coating the active layer may be achieved via a variety of manufacturing techniques (e.g., large scale manufacturing techniques). The manufacturing techniques may include one or more of printing (e.g., ink-jet printing), doctor-blade coating, bar coating, vacuum deposition, roll-to-roll, sheet-to-sheet, slot-die coating, blade coating, gravure printing, spray coating, spin coating, drop casting, flexographic printing, and bar coating. In many embodiments, the deposition and/or coating technique may be used to fabricate the active layer to a desired thickness.

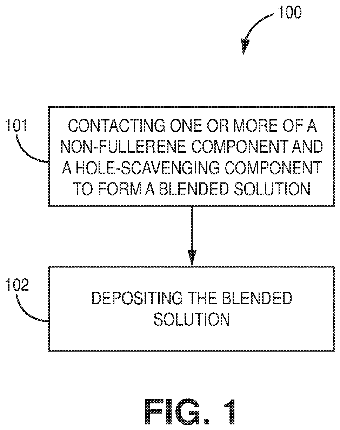

**FIG. 1** is a flowchart of a method **100** of fabricating an active layer of an optoelectronic device, according to one or more embodiments of the present disclosure. As shown in **FIG. 1**, the method **100** comprises contacting **101** one or more non-fullerene components and optionally one or more hole-scavenging components in a presence of a solvent sufficient to form a blended solution; and depositing **102** the blended solution on one or more of a substrate, selective contact layer, and electrode material sufficient to form an active layer of an optoelectronic device.

At step **101,** one or more non-fullerene components and optionally one or more hole-scavenging components are contacted in a presence of a solvent sufficient to form a blended solution. Contacting may include, but is not limited to, mixing, blending, stirring, adding, and dissolving. In many embodiments, the one or more non-fullerene components and optionally the one or more hole-scavenging components are dissolved in the solvent to form the blended solution. In an embodiment, the one or more non-fullerene components is contacted with a solvent to form a solution. In an embodiment, the one or more non-fullerene components and the one or more hole-scavenging components are contacted to form a blended solution.

The one or more non-fullerene components and/or one or more hole-scavenging components may include any of the materials described herein. The amount of the one or more hole-scavenging components and/or the one or more non-fullerene components contacted in the presence of a solvent may be defined by a ratio of the one or more hole-scavenging components to the one or more non-fullerene components. The ratio of the one or more hole-scavenging components to the one or more non-fullerene components is 1:10 to 1:25.

The solvent may include any solvent suitable for dissolving one or more of the one or more non-fullerene components and one or more hole-scavenging components. For example, the solvent may include one or more of organic solvents, inorganic solvents, aqueous-based solvents, polar solvents, and non-polar solvents. In an embodiment, the solvent is an organic solvent. In an embodiment, the solvent is one or more of xylene, tetralin, mesitylene, chloroform, chlorobenzene, and dichlorobenzene. At least one benefit of the present disclosure is that the solvent is or may include an environmentally friendly solvent or a green chemistry solvent. An example of such solvents includes, but is not limited to, one or more of xylene, tetralin, and mesitylene.

At step **102,** the blended solution is deposited on, for example, one or more of a substrate, selective contact layer, and electrode material. Depositing may include, but is not limited to, one or more of printing, coating, casting, and depositing. For example, depositing may include one or more of ink-jet printing, doctor-blade coating, spin-coating, blade-coating, spray-coating, bar-coating, slot-die-coating, knife-coating, roll-coating, wire-bar coating, and dip-coating. In a preferred embodiment, depositing includes spin-coating. For example, a speed (e.g., revolutions per minute (rpm)) of a spin-coating device may be adjusted to obtain different thicknesses of the blended solution and/or active layer. For example, in some embodiments, the blended solution may be deposited at speeds ranging from about 100 rpm to about 5000 pm. In a preferred embodiment, the blended solution is deposited at speeds ranging from about 300 rpm to about 2000 rpm. In another preferred embodiment, depositing may include scalable processes, such as blade-coating. A thickness of the blended solution and/or active layer may be on a length scale ranging from nanometers to centimeters.

The object onto which the blended solution is deposited may depend on the optoelectronic device. In an embodiment, the blended solution is deposited on a substrate. The substrate can be a transparent or substantially transparent substrate, either of which can be optionally coated. Examples of transparent or substantially transparent substrates include, but are not limited to, PET, polycarbonates, and quartz, among other materials, which can be optionally coated. In an embodiment, the substrate may be selected from a transparent or substantially transparent substrate coated with indium tin oxide or fluorine-doped tin oxide. In an embodiment, the blended solution is deposited on a transparent or substantially transparent substrate coated with fluorine-doped tin oxide. In an embodiment, the blended solution is deposited on a transparent or substantially transparent substrate coated with indium tin oxide. These shall not be limiting as other examples are described herein. In another embodiment, the blended solution is deposited on a substrate comprising a selective contact layer. In another embodiment, the blended solution is deposited on a selective contact layer. In another embodiment, the blended solution is deposited on an electrode material.

Embodiments of the present disclosure describe an optoelectronic device. The optoelectronic device may comprise a first electrode material, an active layer, and a second electrode material, wherein the active layer is disposed between the first electrode material and the second electrode material. Any of the active layers of the present disclosure may be used herein. In many embodiments, the active layer either consists essentially of a non-fullerene component, or comprises a non-fullerene component and one or more hole-scavenger components. For example, in an embodiment, the active layer consists essentially of a non-fullerene component. In an embodiment, the active layer comprises a non-fullerene component and a hole-scavenger component. In an embodiment, the active layer comprises a non-fullerene component, a first hole-scavenger component, and a second hole-scavenger component, wherein the first hole-scavenger component and the second hole-scavenger component are different. The non-fullerene component and/or hole-scavenger component may include any of the characteristics or features described in the present disclosure.

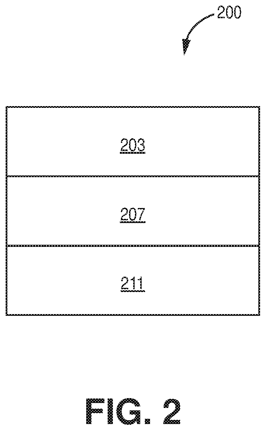

**FIG. 2** is a schematic diagram of an optoelectronic device **200,** according to one or more embodiments of the present disclosure. As shown in **FIG. 2**, the optoelectronic device **200** comprises a first electrode material **203**, an active layer **207**, and a second electrode material **211**. The active layer **207** may be disposed between the first electrode material **203** and the second electrode material **211**. For example, in an embodiment, the active layer **207** may be in contact with a surface of the first electrode material **203** and a surface of the second electrode material **211**, wherein the first electrode material **203** and the second electrode material **211** are on opposing sides of the active layer **207**. In some embodiments, the optoelectronic device **200** may optionally further comprise one or more of a substrate **201** (not shown), a first selective contact layer **205** (not shown), and a second selective contact layer **209** (not shown). In addition or in the alternative, in some embodiments, an interdigitated electrode(s) (not shown) is used.

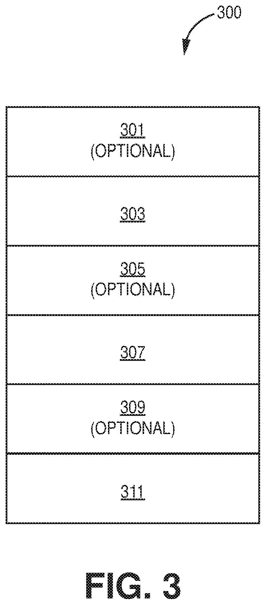

**FIG. 3** is a schematic diagram of an optoelectronic device **300** showing the optional layers of an optoelectronic device, according to one or more embodiments of the present disclosure. As shown in **FIG. 3**, the optoelectronic device **300** comprises one or more of a substrate **301**, a first electrode material **303**, a first selective contact layer **305**, an active layer **307**, a second selective contact layer **309**, and a second electrode material 311, wherein one or more of the substrate **301**, first selective layer **305**, and second selective layer **309** are optionally included in the optoelectronic device **300**. The active layer **307** may be disposed between the first electrode material **303** and the second electrode material **311**. In an embodiment, the first selective contact layer **305** is positioned between and in contact with the first electrode material **303** and the active layer **307**. In an embodiment, the second selective contact layer **309** is positioned between and in contact with the second electrode material **311** and the active layer **307**. In an embodiment, the substrate **301** is in contact with the first selective contact layer **305** and otherwise exposed to an environment. In an embodiment, the substrate is in contact with the second selective contact layer **309** and otherwise exposed to an environment. In an embodiment, the optoelectronic device may be configured as substrate/first electrode material/first selective contact layer/active layer/second selective contact layer/second electrode material. In addition or in the alternative, in some embodiments, an interdigitated electrode (not shown) is used.

In an embodiment, the optoelectronic device **300** is a multi-junction or tandem solar cell. The tandem solar cell may comprise a substrate **301**, a first electrode material **303**, a first selective contact layer **305**, an active layer **307**, a second selective contact layer **309**, and a second electrode material **311**, wherein the substrate **301** is another solar cell. The solar cell, as the substrate **301**, can include, but is not limited to, amorphous silicon (a-Si), perovskite crystal structures, solid-state dye sensitized structures, liquid-electrolyte dye sensitized structures, cadmium telluride materials, cadmium sulfide materials, and gallium arsenide materials, among others. For example, the substrate **301** may comprise a layer of amorphous silicon (a-Si) positioned between, and in contact with, the first electrode material **303** and another electrode material (not shown). In an embodiment, the first electrode material **303** is included in or considered a part of the another solar cell **301**. Glass may be positioned on, and in contact with, an opposing surface of the another electrode material. In these embodiments, the front cell (or a-Si subcell) may be based on the layer of amorphous silicon (a-Si), which absorbs some light in the visible region (while allowing some visible light to pass, retaining some transparency), while allowing the invisible (near infrared) wavelengths to pass through freely and be absorbed by the "back cell" (or OPV subcell), which comprises the diluted systems described herein.

In an embodiment, the optoelectronic device **300** comprises a tandem solar cell comprising a first subcell (e.g., an organic photovoltaic (OPV) subcell), a substrate, and a second subcell (e.g., an amorphous silicon (a-Si) subcell, perovskite crystal structures, solid-state dye sensitized structures, liquid-electrolyte dye sensitized structures, cadmium telluride materials, cadmium sulfide materials, and gallium arsenide materials, etc.) positioned between the first subcell and the substrate. In an embodiment, an OPV subcell comprises the first selective contact layer **305**, the active layer **307**, the second selective contact layer **309**, the second electrode material **311**, and optionally the first electrode material **303**. In an embodiment, an a-Si subcell **301** comprises a third electrode material (not shown), a layer of amorphous silicon (not shown), and optionally the first electrode material **303**. The layer of amorphous silicon may comprise negatively doped, undoped, and/or positively doped a-Si:H. In an embodiment, the substrate is glass.

In an embodiment, the optoelectronic device **300** is an inverted optoelectronic device. The inverted optoelectronic device may comprise a substrate **301**, a first electrode material **303**, a first selective contact layer **305**, an active layer **307**, a second selective contact layer **309**, and a second electrode material **311**. In embodiments in which the optoelectronic device is inverted, the first selective contact layer **305** is n-type and the second selective contact layer **309** is p-type.

In an embodiment, the optoelectronic device **300** is a non-inverted optoelectronic device, with a conventional or normal architecture. The non-inverted optoelectronic device may comprise a substrate **301**, a first electrode material **303**, a first selective contact layer **305**, an active layer **307**, a second selective contact layer **309**, and a second electrode material **311**. In embodiments in which the optoelectronic device is non-inverted, the first selective contact layer **305** is p-type and the second selective contact layer **309** is n-type.

The optoelectronic device **200** or **300** may comprise one or more electrode materials. For example, the optoelectronic device may comprise one or more of a first electrode material **303** and a second electrode material **311**. In many embodiments, one or more of the first electrode material **303** and the second electrode material **311** may be transparent. In an embodiment, at least one of the first electrode material **303** and the second electrode material **311** is transparent. In an embodiment, the first electrode material **303** and the second electrode material **311** are transparent. In embodiments in which the first electrode material **303** and the second electrode material **311** (and any other layers) are transparent and combined with the active layers **307** of the present disclosure, the entire optoelectronic device may exhibit high transparency in a range visible to the human eye (i.e., a "transparent" optoelectronic device).

In an embodiment, either the first electrode material **303** or the second electrode material **311** may be a high work function conductive electrode and the other electrode material may be a low work function conductive electrode. For example, a cathode may comprise a high work function metal or metal oxide and/or an anode may comprise a low work function metal. In these embodiments, the optoelectronic device (e.g., an organic solar cell) may be characterized as comprising an inverted configuration. In other embodiments, the optoelectronic device may be characterized as comprising a non-inverted configuration (e.g., a conventional or normal configuration). Accordingly, the first electrode material **303** and the second electrode material **311** may selected based on an architecture of the optoelectronic device (e.g., based on inverted configurations and non-inverted configurations).

One or more of the first electrode material **303** and the second electrode material **311** may be one or more of a doped oxide, metallic conductor, conducting polymer, and carbon-based conductor.

The doped oxide may include any material with high concentrations of free electrons. For example, the doped oxide may include one or more of a metal oxide semiconductor and conductor. In an embodiment, the doped oxide may include one or more of indium-doped tin oxide (ITO), fluoride-doped tin oxide (FTO), aluminum-doped zinc oxide (AZO),

and $In_2O_3$.

The metallic conductor may include any metals with complementary work functions with respect to the HOMO/LUMO of the charge selective layers, allowing, for example, favorable electron or hole transfer between layers. The metallic conductor may be one or more of a solid, grid, and wire-mesh array. In many embodiments, the metallic conductor includes one or more of silver, gold, aluminum, copper, titanium, zinc, steel, and chromium.

The conducting polymer may include any material with high conductivity and/or transparency. For example, the conducting polymer may include PEDOT:PSS.

The carbon-based conductor may include one or more of graphene, carbon black, graphite, carbon nanotubes, and carbon nanowires. For example, in some embodiments, the carbon-based conductor includes one or more of a single-wall carbon nanotube, a single-wall carbon nanowire, multi-wall carbon nanotube, and multi-wall carbon nanowire, where the carbon single-wall or multi-wall nanotube or nanowire structures are sufficiently narrow in one dimension so as to allow for high optical transparency while maintaining high electrical conductivity. Typical concentrations of carbon nanotubes and nanowires in an ink range between about 0.001% and about 1%, but typically may be about 0.1% by weight. In the case of graphene, graphene oxide and graphite, the number of carbon atom layers should be low enough to allow for high optical transparency while maintaining high electrical conductivity. Layer thicknesses typically range between 1 and 10 atoms thickness, preferably 1. The dimensions of these carbon sheets ranges between 5 $\mu$m and 10,000 $\mu$m, typically 50 $\mu$m. In the case of graphite and carbon black, a sufficiently small addition of these material may be used in conjunction with a high optical transparency electrical conductor to further improve conductivity without imparting a high degree of opacity.

The optional substrate **301** may include any suitable substrate. In some embodiments, suitable substrates may include substrates with a high degree of flatness on a micron-scale or smaller. In some embodiments, suitable substrates may include transparent substrates, while in other embodiments, suitable substrates may be one or more of non-transparent, partially transparent, or substantially transparent. The substrates can optionally be coated (e.g., with ITO, FTO, etc.). In many embodiments, the optional substrate **301** may include one or more of glass, metallic, polymer, and ceramic. The glass substrate may include one or more of soda-lime glass, borosilicate glass, fused silica glass, and aluminosilicate glass. The metallic substrate may include one or more of titanium, nickel, iron, zinc, and copper. The polymer substrate may include one or more of PET, PEN, PU, PC, PMMA, PETG, silicone, polyetherimide (PEI), nylon/PA, PE, and PP. The ceramic substrate may include one or more of aluminum oxide, silicon dioxide, quartz, slate, kaolinite, montmorillonite-smectite, illite, chlorite, and calcium aluminate.

The optional first selective contact layer **305** and/or optional second selective contact layer **309** may include one or more of a p-type selective contact layer and a n-type selective contact layer. In embodiments in which the optoelectronic device is a non-inverted optoelectronic device, the first selective contact layer **305** is a p-type selective contact layer and the second selective contact layer **309** is a n-type selective contact layer. In embodiments in which the optoelectronic device is an inverted optoelectronic device, the first selective contact layer **305** is a n-type selective contact layer and the second selective contact layer **309** is a p-type selective contact layer. The p-type selective contact layer may include one or more of PEDOT:PSS, nickel oxide, graphene, fluorine-doped $CsSnI_3$, perovskites, metal-phthalocynanine (e.g., copper-phthalocyanine), CuI, PFN, metal-thiocyanate, and derivatives thereof. The n-type selective layer may include one or more of phthalocyanine, polyacetylene, poly(phenylene vinylene), and derivatives thereof. In addition or in the alternative, the first selective layer and/or second selective layer may include bathocuproine and/or metal oxide semiconductors. The metal oxide semiconductors may include one or more of $TiO_2$, $ZnO$, $SnO_2$, $Nb_2O_5$, $SrTiO_3$, $NiO$, $WO_3$, $V_2O_5$, indium tin oxide, fluorine-doped tin oxide, and mixtures thereof.

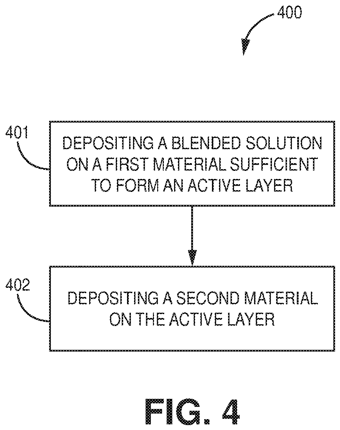

**FIG. 4** is a flowchart of a method of fabricating an optoelectronic device, according to one or more embodiments of the present disclosure. As shown in **FIG. 4**, the method **400** comprises depositing **401** a blended solution on a first material sufficient to form an active layer, wherein the blended solution includes a non-fullerene component and optionally one or more hole-scavenging components; and depositing **402** a second material on the active layer, wherein the first material and the second material are on opposing sides of the active layer.

Depositing may include any of the techniques described in the present disclosure. For example, the depositing may include one or more of printing, doctor-blade coating, bar coating, slot-die coating, spin-coating, blade-coating, and spray-coating. In many embodiments, depositing includes spin-coating. Any of the non-fullerene components and hole-scavenging components of the present disclosure may be used here. In an embodiment, the blended solution consists essentially of a non-fullerene component. In an embodiment, the blended solution comprises a non-fullerene component. In an embodiment, the blended solution comprises a non-fullerene component and one or more hole-scavenging components. In an embodiment, the blended solution consists essentially of a non-fullerene component and one or more hole-scavenging components.

The first material and the second material may include any layers or components of an optoelectronic device. In an embodiment, the first material refers to one or more of a substrate, a first electrode material, and a first selective contact layer. In an embodiment, the first material refers to one or more of a second electrode material and a second selective contact layer. In an embodiment, the second material refers to one or more of a substrate, a first electrode material, and a first selective contact layer. In an embodiment, the second material refers to a second electrode material and a second selective contact layer. In an embodiment, the method comprises depositing a first precursor solution, wherein the first precursor solution forms a first selective contact layer. In an embodiment, the method comprises depositing a second precursor solution, wherein the second precursor solution forms a second selective contact layer.

In an embodiment, the method may comprise preparing a blended solution, wherein the blended solution includes a non-fullerene component and one or more hole-scavenging components dissolved in an organic solvent (e.g., an environmentally friendly or green chemistry solvent). In an embodiment, the method may comprise washing a substrate. For example, the substrate may be washed with one or more of detergent water, deionized water, acetone, and isopropyl alcohol. In an embodiment, the washing may include washing in an ultrasonic bath for a specified period of time. In an embodiment, the method may comprise preparing a precursor solution of a first or second selective layer. In an embodiment, the method may comprise treating the substrate. For example, the substrate may be subjected to UV-ozone treatment. In an embodiment, the precursor solution of the first or second selective layer may be spin coated onto the substrate and/or a composite comprising the substrate and the first or second selective layer. In an embodiment, the method comprises heating the deposited precursor solution. In an embodiment, the method comprises spin-coating the blended solution on any layer of the optoelectronic device. In an embodiment, the method may comprise depositing a layer via thermal evaporation.

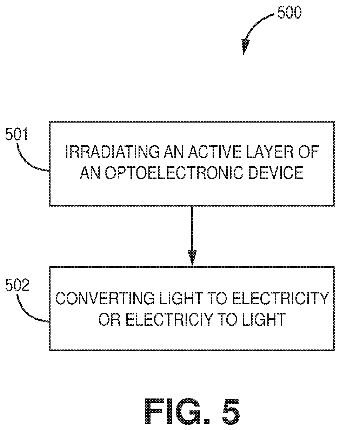

FIG. 5 is a flowchart of a method 500 of using an optoelectronic device, according to one or more embodiments of the present disclosure. As shown in FIG. 5, the method 500 comprises irradiating 501 a surface of an optoelectronic device comprising an active layer, wherein the active layer comprises a non-fullerene component and optionally one or more hole-scavenging components; and converting 502 light to electricity or electricity to light. In many embodiments, the active layer is a photoactive layer. In an embodiment, the active layer consists essentially of a non-fullerene component. In an embodiment, the active layer comprises a non-fullerene component. In an embodiment, the active layer comprises a non-fullerene component and one or more hole-scavenging components. In an embodiment, the active layer consists essentially of a non-fullerene component and one or more hole-scavenging components.

Irradiating generally refers to exposing to radiation. The radiation may comprise any wavelength, frequency, or range thereof of the electromagnetic spectrum. In many embodiments, irradiating includes exposing to near-infrared radiation. In other embodiments, irradiating includes exposing to visible light. In other embodiments, irradiating includes exposing to any radiation on the electromagnetic spectrum. Converting generally refers to any process for converting energy.

The following Examples are intended to illustrate the above invention and should not be construed as to narrow its scope. One skilled in the art will readily recognize that the Examiners suggest many other ways in which the invention could be practiced. It should be understand that numerous variations and modifications may be made while remaining within the scope of the invention.

## EXAMPLE 1

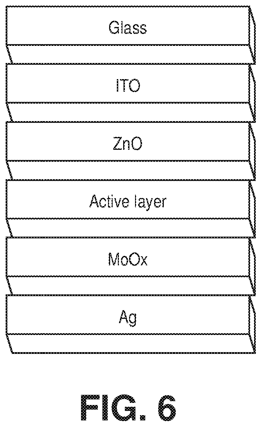

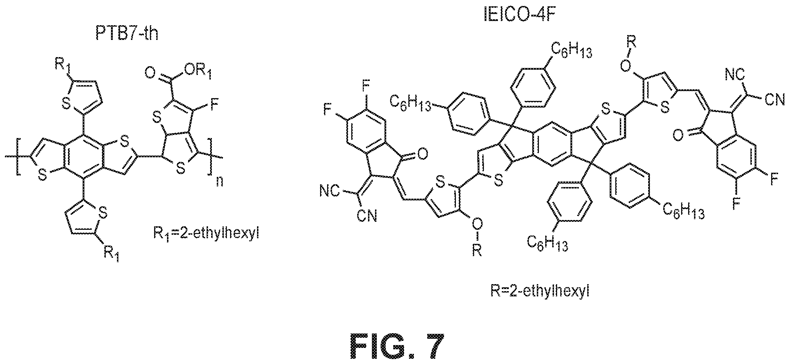

The Example described herein relates to novel single component and diluted systems. In particular, due to the different photophysical characteristics of NF compared to $PC_{70}BM$, a "diluted" system (D/A 1:10-1:25) was fabricated, which in combination with an infrared acceptor can feature AVT > 70% and, at the same time, delivery PCE > 5-6%. Ultra-fast (< 300 fs) transient absorption spectroscopy (TAS) revealed that the non-fullerene acceptors featured intrinsic semiconductor properties, rather than excitonic. This is different from common donor and fullerene-based materials. In fact, the formation of free charges in the pristine non-fullerene acceptor material was observed in an ultra-short time scale, whereas the common state-of-the-art donors and acceptors depicted solely excitons. To prove the measurements, a single component organic solar cells (which could be alternatively named 0:1 diluted systems), based on IEICO-4F NF was fabricated in an inverted configuration based on ITO/ZnO/non-fullerene acceptor/MoOx/Ag (FIG. 6). FIG. 7 shows the current density versus voltage (J-V) characteristics of the single component device under AM1.5G illumination at 100 mWcm$^{-2}$. The solar cell delivered a short circuit current density ($J_{sc}$) of 3 mA cm$^{-2}$, an open-circuit voltage ($V_{oc}$) of 0.77 V, a fill factor of 32%, and an overall PCE of ~ 1%. This result confirmed that the non-fullerene acceptors were able to efficiently split the excitons into free charges at room temperature without the need of a donor material and to collect holes and electrons in their respectively electrodes, due to the ambipolar nature of NFs. However, the limited PCE of the single component devices was attributed to the non-ohmic contact of the HOMO/LUMO level with the HTL and ETL, respectively and/or charge recombination processes in the material, due to defects and/or trap states formation.

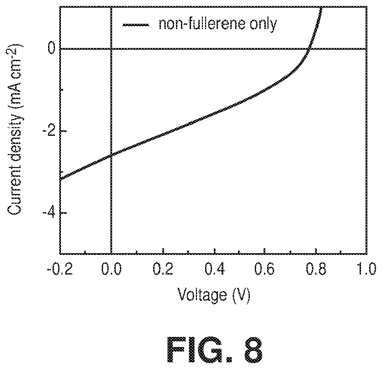

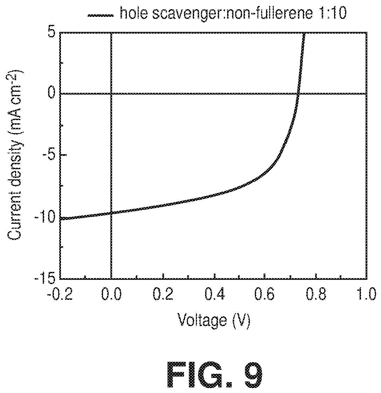

To reduce these limitations, a low amount of donor material (PTB7-th) was introduced to form diluted systems, in which the polymer/small molecule act as "hole scavenger" promoting the extraction of charges and therefore improving both FF and $J_{sc}$ compared to the single component devices. FIG. 8 shows the current density versus voltage (J-V) characteristics the single component device under AM1.5G illumination at 100 mWcm$^{-2}$. The diluted system PTB7-Th:IEICO-4F devices delivered a PCE of 5% with 1:10 D/A. FIG. 9 is a graphical view of a diluted system comprising a ratio of hole-scavenging component to non-fullerene component of 1:10. Finally, a wide range of donor/NF systems were fabricated, making the approach of the present disclosure universal. In particular, this method provides an opportunity to reconsider all donor materials developed in the last 20 years for use in transparent organic opto-electronic devices.

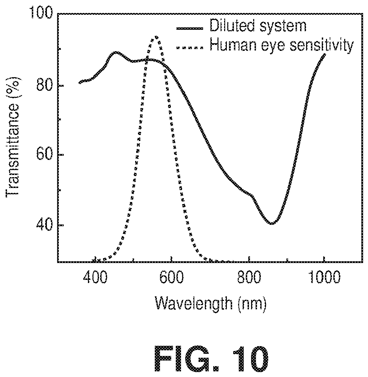

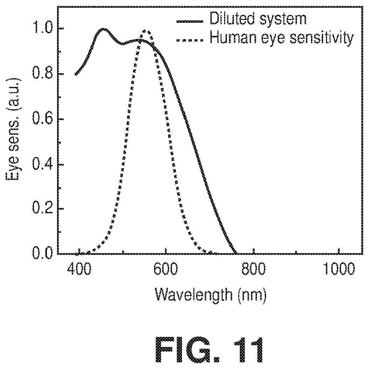

Interestingly, the AVT of the active layers of the diluted system based on PTB7-th:IEICO-4F were measured by UV/Vis spectroscopy. **FIG. 10** shows the transmittance of the BHJ with respect the human eye sensitivity. An AVT of 70% was calculated for the all wavelength range (360-1000 nm), the highest reported so far for organic solar cells. Moreover, the transparency of the active layer was calculated according to the human eye response (**FIG. 11**). Transparency values as high as 90% were obtained for PTB7-th:IEICO-4F film. This is impressive, considering that the bare glass reduced the transparency up to 5-8%.

Photovoltaic modules represented an important test bed because real-world applications typically require large voltage outputs, which can be achieved through monolithic interconnection of consecutive cells. High solar module efficiencies were achieved on glass and on flexible substrates, importantly whilst maintaining a high AVT and GFF.

*Fabrication and Characterization of OSCs.* PTB7-Th was purchased from 1-Materials Inc. IEICO-4F was synthesized using conventional methods. PTB7-Th: IEICO-4F blend solution was prepared in chlorobenzene with a concentration of 20 mg/ml. The inverted device structure was ITO/zinc oxide (ZnO)/PTB7-Th: IEICO-4F/MoOx/Ag. ITO substrates were cleaned with detergent water, deionized water, acetone and isopropyl alcohol in an ultrasonic bath sequentially for 20 min. Zinc oxide precursor solution was prepared by dissolving 2.4 g of zinc acetate dihydrate ($Zn(CH_3COO)_2 \cdot 2H_2O$, 99%, Sigma) and 0.647 ml of ethanolamine ($NH_2CH_2CH_2OH$, 98%, Sigma) in 30 ml of 2-methoxyethanol ($CH_3OCH_2CH_2OH$, 98%, Sigma), then stirring the solution overnight. The ITO substrates were under UV-Ozone treatment for 30 min. After the UV-Ozone treatment, ZnO precursor solution was spin coated at 4000 rpm onto the ITO substrates. After being baked at 200 °C for 10 min in air, the ZnO-coated substrates were transferred into nitrogen-filled glove box. The donor/acceptor blend solution was spin coated with different speed (300 rpm to 2000 rpm) to obtain different thickness. The device fabrication was completed by thermal evaporation of 5 nm MoOx (Alfa) and 100 nm Ag (Kurt Lesker) at a pressure of less than $2 \times 10^{-6}$ Pa. The active area of all devices was 0.1 cm$^2$ through a shadow mask. J-V measurements of solar cells were performed in the glovebox with a Keithley 2400 source meter and an Oriel Sol3A Class AAA solar simulator calibrated to 1 sun, AM1.5 G, with a KG-5 silicon reference cell certified by Newport.

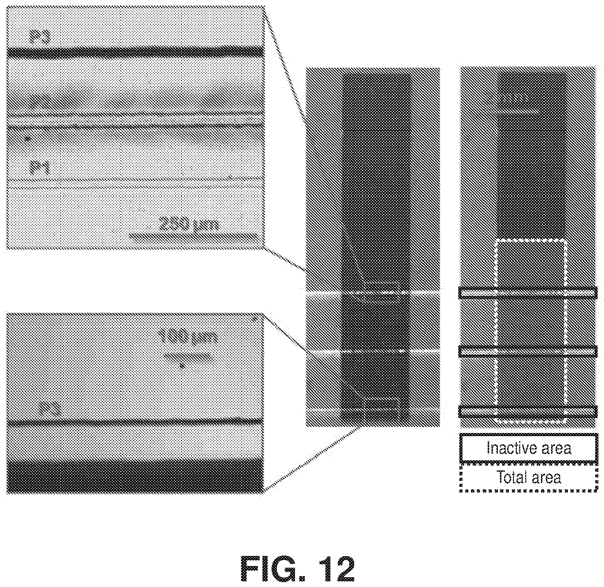

*Module.* The process involved high precision, ultrafast laser structuring of sequential, uniformly coated layers to form interconnects with low series resistance and reduced dead area. Glass/ITO and PET/ITO-Ag-ITO (IMI) substrates were used to realize both rigid and flexible devices, respectively. In order to achieve functional modules, three laser steps were necessary: the P1 laser defined the bottom electrode, the P2 line "opened" the photoactive layer to create a contact between top and bottom electrode and P3 electrically separated the top electrode (**FIG. 12**). The area between the P1 and the P3 line was not photo-active and thus can be considered a loss region (dead area).

This gives rise to the geometric fill factor (GFF), which is defined as

$$GFF = 100\left(1 - \frac{DeadArea}{TotalArea}\right)\%.$$

The closer the GFF to 100%, the lower the impact of the patterning technique on the final PCE of the solar module. The laser structuring made it possible to achieve interconnection regions of 250 - 300 $\mu$m and thus GFFs as high as 90%.

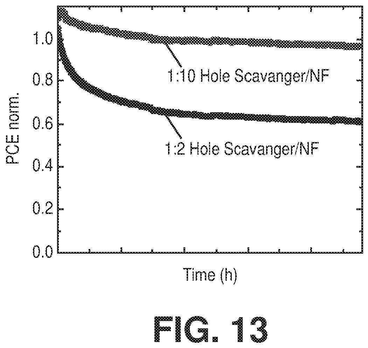

**FIG. 13** is a graphical view of normalized PCE of 1:2 and 1:10 D/A based solar cells in the course of light exposure, according to one or more embodiments of the present disclosure. Upon device fabrication, the solar cells were placed in a sealed, electronically controlled degradation chamber with regulated environment ($O_2$ < 1ppm, $H_2O$ < 1ppm). The J-V characteristics of both 1:2 Hole Scavenger/NF and 1:10 Hole Scavenger/NF based devices were probed periodically while continuously light-soaked using a metal halide lamp irradiating at 100 mW/cm$^2$. As depicted in **FIG. 13**, the 1:10 Hole Scavenger/NF based solar cells show improved photostability compared to the 1:2 Hole Scavenger/NF based devices.

### EXAMPLE 2

### Ternary Diluted Systems

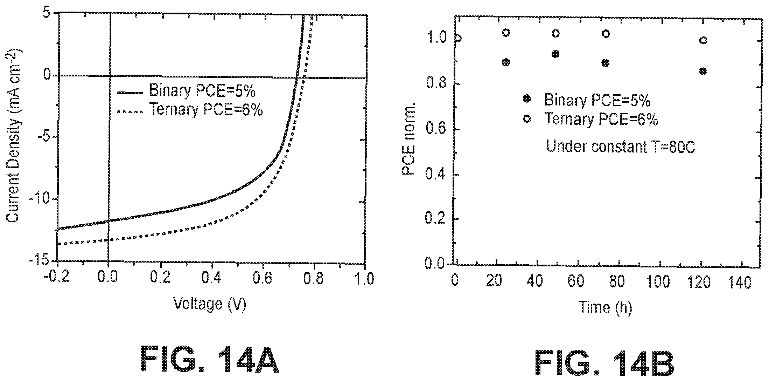

Organic ternary bulk heterojunction (BHJ) blends containing two electron donating and one electron accepting organic moieties (or vice versa) are among the most auspicious material systems deemed promising to overcome the important barrier of 15% power conversion efficiency (PCE) of organic photovoltaics (OPV). Using a third semiconducting absorber in the bulk heterojunction blend, the three key photovoltaic parameters, short-circuit current density (Jsc), open circuit voltage (Voc) and fill factor (FF) can, in principle, be manipulated and enhanced compared to devices based on binary blends. In this Example, an active layer based on a non-fullerene and two hole scavengers was used, but other combinations are possible (e.g., two non-fullerenes and one hole-scavenger, among others).With this approach a dual improvement of the power conversion efficiency and the thermal stability for the ternary blends was obtained when compared with the reference devices based on a non-fullerene and one hole scavenger. In fact, ternary devices delivered a PCE of 6%, whereas binary cells showed lower PCE of 5%. Moreover, temperature degradation measurements carried out in inert atmosphere at 80 degrees C show improved stability for ternary blends compared to binary devices. The results are reported in **FIGS. 14A-14B**.

### EXAMPLE 3

### Diluted Systems Coated on Commercially Available Glass

The common substrate used for organic solar cells consists of a glass coated with Indium Tin Oxide (ITO) characterized by low sheet resistance (<15 Ohm/sq) and low roughness (<1 nm). The low roughness allows the fabrication of organic solar cells without any defects and/or pin holes, which would have a detrimental effect on the performances. For commercial valuable product, ITO has to be replaced by Fluorine doped Tin Oxide (FTO), for costing perspective. However, conventional organic solar cells feature low efficiency when fabricated on FTO for the higher roughness of the substrate compared to ITO. In this Example, organic solar cells based on non-fullerene and one or more hole scavengers were fabricated on commercially available FTO. The devices delivered comparable PCE with the standard ITO-based solar cells. The short-circuit current density was the only parameter affected by the substrate replacement, due to the higher parasitic absorption in the NIR of FTO compared to ITO. It was found that the diluted systems featured a higher tolerance toward defect/roughness of the substrate compare to convention donor:acceptor blends. The results are reported in Table 1.

Table 1. Photovoltaic parameters of hole scavenger:NF (1:10) based devices at 1 sun illumination on different glass/FTO and glass/ITO substrates.

|  | Jsc (mA/cm2) | Voc (V) | Fill Factor | PCE (%) | Ohms/sq | RMS (nm) |
|---|---|---|---|---|---|---|
| Commercial FTO-1 | 10.1 | 0.70 | 0.59 | 4.18 | 30.000 | 5.000 |
| Commercial FTO-2 | 9.8 | 0.71 | 0.56 | 3.89 | 15.000 | 8.000 |
| Commercial FTO-3 | 8.5 | 0.71 | 0.59 | 3.56 | 10.000 | 10.000 |
| Commercial FTO-4 | 10.2 | 0.68 | 0.40 | 2.77 | 15.000 | 17.000 |
| Commercial FTO-5 | 12.3 | 0.72 | 0.58 | 5.13 | 8.0 | 12.0 |
| ITO | 12.5 | 0.73 | 0.60 | 5.48 | 10.0 | 3.0 |

### EXAMPLE 4

### Hybrid Tandem Solar Cells

Typical solar cells are based on a single layer of photovoltaic material, whether it be based on silicon, perovskite, or an organic bulk heterojunction. However, there are fundamental physical limits to how efficient this single layer is at converting light into electricity: In the best case, this efficiency ceiling is around 33%. However, as described herein, by 'stacking' multiple photovoltaic materials on top of one another in the same device (known as 'multi-junction' or 'tandem' solar cells), light was harvested more efficiently, and the 33% efficiency limit was raised. Importantly, it was necessary for the short-circuit current density (JSC) of both sub-cells to be as similar as possible in order to realize efficient tandem solar cells (The JSC of the tandem device is limited to the lowest sub-cell's JSC, while the open-circuit voltages, VOCs, of the sub-cells are summed).

Accordingly, a process of fabricating the diluted organic systems described herein using another solar cell as a substrate was developed. This 'front cell' was based on a layer of amorphous silicon (a-Si) which absorbs some light in the visible region of the solar spectrum (while allowing some visible light to pass, retaining some transparency), whilst allowing the invisible (near infrared) wavelengths to pass through freely and be absorbed by the diluted organic 'back cell' as described herein. Such tandem solar cells can greatly improve the efficiency of a-Si solar cells with no significant disadvantages compared to pristine a-Si alone. The diluted organic photovoltaic materials described herein exhibited nearly identical JSC compared to standard a-Si solar cell while maintaining high visible transparency. This meant the new tandem device exhibited a much higher VOC (and hence, efficiency) with no appreciable decrease in the visual transparency or JSC limitations. The front cell can be based on other materials, including, but not limited to, perovskite crystal structures, solid-state dye sensitized structures, liquid-electrolyte dye sensitized structures, cadmium telluride materials, cadmium sulfide materials, and gallium arsenide materials, among others.

This device structure is envisaged to be used in commercial applications where a slightly 'darker' solar panel is required, wherein the optical properties can still be tuned by varying the donor and acceptor ratios as described in the present disclosure.

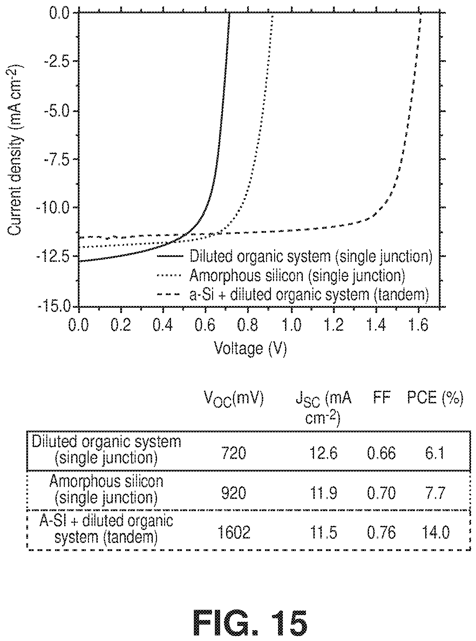

**FIG. 15** shows the current-voltage reponses of single-junction organic (blue), single-junction a-Si (red) and multi-junction tandem solar cells (orange). The underlying table shows that by utilizing this tandem structure, the power conversion efficiency of an a-Si solar cell was improved from 7.7% to 14.0%.

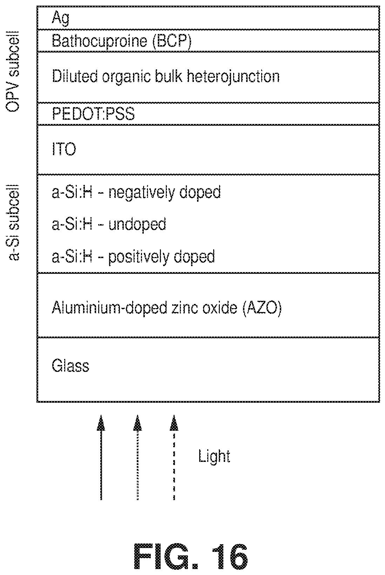

**FIG. 16** is a schematic drawing of a tandem solar cell, according to one or more embodiments of the present disclosure.

Other embodiments of the present disclosure are possible. Although the description above contains much specificity, these should not be construed as limiting the scope of the disclosure, but as merely providing illustrations of some of the presently preferred embodiments of this disclosure. It is also contemplated that various combinations or sub-combinations of the specific features and aspects of the embodiments may be made and still fall within the scope of this disclosure. It should be understood that various features and aspects of the disclosed embodiments can be combined with or substituted for one another in order to form various embodiments. Thus, it is intended that the scope of at least some of the present disclosure should not be limited by the particular disclosed embodiments described above.

Thus the scope of this disclosure should be determined by the appended claims and their legal equivalents. Therefore, it will be appreciated that the scope of the present disclosure fully encompasses other embodiments which may become obvious to those skilled in the art, and that the scope of the present disclosure is accordingly to be limited by nothing other than the appended claims, in which reference to an element in the singular is not intended to mean "one and only one" unless explicitly so stated, but rather "one or more." All structural, chemical, and functional equivalents to the elements of the above-described preferred embodiment that are known to those of ordinary skill in the art are expressly incorporated herein by reference and are intended to be encompassed by the present claims. Moreover, it is not necessary for a device or method to address each and every problem sought to be solved by the present disclosure, for it to be encompassed by the present claims. Furthermore, no element, component, or method step in the present disclosure is intended to be dedicated to the public regardless of whether the element, component, or method step is explicitly recited in the claims.

The foregoing description of various preferred embodiments of the disclosure have been presented for purposes of illustration and description. It is not intended to be exhaustive or to limit the disclosure to the precise embodiments, and obviously many modifications and variations are possible in light of the above teaching. The example embodiments, as described above, were chosen and described in order to best explain the principles of the disclosure and its practical application to thereby enable others skilled in the art to best utilize the disclosure in various embodiments and with various modifications as are suited to the particular use contemplated. It is intended that the scope of the disclosure be defined by the claims appended hereto

Various examples have been described. These and other examples are within the scope of the following claims.

**Claims**

1. An active layer of an optoelectronic device, the active layer comprising:

   > one or more non-fullerene materials; and
   > one or more hole-scavenging materials;
   > wherein the one or more non-fullerene materials are intimately mixed with the one or more hole-scavenging materials, and where a ratio of the one or more hole-scavenging components to the one or more non-fullerene components in the active layer ranges from 1:10 to 1:25, and wherein the active layer has an average visible transmission of greater than 70%,
   > wherein the one or more hole scavenging materials include one or more of thiophene, acene, fluorine, carbazole, indacenodithieno thiophene, indacenothieno thiphene, benzodithiazole, thieny-benzodithiophene-dione, benzotriazole, and diketopyrrolopyrrole.

2. The active layer according to claim 1, wherein the one or more hole-scavenging components comprise a first hole-scavenging material and a second hole-scavenging material, wherein the first hole scavenging material and the second hole-scavenging material are different.

3. The active layer according to any one of claims 1 and 2, wherein the non-fullerene material includes one or more of rhodanine-benzothiadiazole-coupled indacenodithiophene (IDTBR); indacenodithieno[3,2-b]thiophene, IT), end-capped with 2-(3-oxo-2,3-dihydroinden-1-ylidene)malononitrile (INCN) groups (ITIC); indaceno[1,2-b:5,6-b']dithiophene and 2-(3-oxo-2,3-dihydroinden-1-ylidene)malononitrile (IEIC); 2,2'-((2Z,2'Z)-((5,5'-(4,4,9,9-tetrakis(4-hexylphenyl)-4,9-dihydro-s-indaceno[1,2-b:5,6-b']dithiophene-2,7-diyl)bis(4-((2-ethylhexyl)- oxy)thiophene-5,2-diyl))bis(methanylylidene))bis(3-oxo-2,3-di- hydro-1H-indene-2,1-diylidene))dimalononitrile (IEICO); naphthalene diimide (NDI); bay-linked perylene bisimide (di-PBI); perylene bisimide (PBI); Naphthalocyanine (NC); Phthalocyanine (PC); Naphtho[1,2- c :5,6- c ']bis[1,2,5]thiadiazole; (2E,2'E)-3,3'-(2,5-dimethoxy-1,4-phenylene)bis(2-(5-(4-(N-(2-ethylhexyl)-1,8-naphthalimide)yl)thiophen-2-yl)acrylonitrile) (NIDCS-MO); thieno[3,4-b] thiophene and 2-(1,1-dicyanomethylene)rhodanine combination (ATT-1); (3,9-bis(4-(1,1-dicyanomethylene)- 3-methylene-2-oxo-cyclopenta[b]thiophen)-5,5,11,11-tetrakis(4-hexylphenyl)-dithieno[2,3-d':2,3-d']-s-indaceno[1,2-b:5,6- b']-dithiophene (ITCC); Indanedione; Dicyannovinyl; Benzothiadiazole; and Diketopyrolopyrrole.

4. The active layer according to any one of claims 1 or 2, wherein the non-fullerene material includes arylene diimide.

5. The active layer according to any one of claims 1-4, wherein the active layer consists essentially of the one or more non-fullerene components and the one or more hole-scavenging components.

6. The active layer according to any one of claims 1-4, wherein the active layer consists of the one or more non-fullerene components and the one or more hole-scavenging components.

7. An optoelectronic device, comprising:

   a first electrode material;
   an active layer according to any one of claims 1-7; and
   a second electrode material;
   wherein the first electrode material and the second electrode material are on
   opposing sides of the active layer.

8. The optoelectronic device according to claim 7, wherein the optoelectronic device is one or more of an organic photovoltaic, organic photodiode, organic light-emitting diode, organic photo field-effect transistor, photodetector, and paraelectric.

9. A tandem solar cell, comprising:

   a substrate;
   a first subcell including at least an active layer according to any one of claims 1-7; and
   a second subcell selected from amorphous silicon, perovskite crystal structures, solid-state dye sensitized structures, liquid-electrolyte dye sensitized structures, cadium telluride materials, cadmium sulfide materials, and gallium arsenide materials;
   wherein the first subcell and the substrate are on opposing sides of the second subcell.

10. The solar cell according to claim 9, wherein the first subcell absorbs at least a portion of light in the near-infrared region of the electromagnetic spectrum.

11. The solar cell according to any one of claims 9 or 10, wherein the second subcell absorbs at least a portion of light in the visible region of the electromagnetic spectrum.

**Patentansprüche**

1. Aktive Schicht einer optoelektronischen Vorrichtung, die aktive Schicht umfassend:

   ein oder mehrere Nicht-Fulleren-Materialien; und
   ein oder mehrere Loch-Scavenger-Materialien;
   wobei das eine oder die mehreren Nicht-Fulleren-Materialien eng mit dem einen oder den mehreren Loch-Scavenger-Materialien gemischt sind, und wobei das Verhältnis der einen oder der mehreren Loch-Scavenger-Komponenten zu der einen oder den mehreren Nicht-Fulleren-Komponenten in der aktiven Schicht in einem Bereich von 1:10 bis 1:25 ist, und wobei die aktive Schicht eine durchschnittliche sichtbare Transmission von mehr als 70 % aufweist,

wobei das eine oder die mehreren Loch-Scavenger-Materialien eines oder mehrere von Thiophen, Acen, Fluor, Carbazol, Indacenodithieno-Thiophen, Indacenothieno-Thiphen, Benzodithiazol, Thieny-Benzodithiophen-Dion, Benzotriazol und Diketopyrrolopyrrol beinhalten.

2. Aktive Schicht nach Anspruch 1, wobei die eine oder die mehreren Loch-Scavenger-Komponenten ein erstes Loch-Scavenger-Material und ein zweites Loch-Scavenger-Material umfassen, wobei das erste Loch-Scavenger-Material und das zweite Loch-Scavenger-Material verschieden sind.

3. Aktive Schicht nach einem der Ansprüche 1 und 2, wobei das Nicht-Fulleren-Material eines oder mehrere von Folgenden beinhaltet: Rhodanin-Benzothiadiazolgekoppeltes Indacenodithiophen (IDTBR); Indacenodithieno[3,2-b]thiophen (IT), das mit 2-(3-Oxo-2,3-dihydroinden-1-yliden)malononitril (INCN)-Gruppen (ITIC) endverkappt ist; Indaceno[1,2-b:5,6-b']dithiophen und 2-(3-Oxo-2,3-dihydroinden-1-yliden)malononitril (IEIC); 2,2'-((2Z,2'Z)-((5,5'-(4,4,9,9-tetrakis(4-hexylphenyl)-4,9-dihydro-s-indaceno[1,2-b:5,6-b']dithiophen-2,7-diyl)bis(4-((2-ethylhexyl)-oxy}thiophen-5,2-diyl))bis(methanylyliden))bis(3-oxo-2,3-di-hydro-1H-inden-2,1-diyliden))dimalonitril (IEICO); Naphthalindiimid (NDI); bay-verknüpftes Perylenbisimid (di-PBI); Perylenbisimid (PBI); Naphthalocyanin (NC); Phthalocyanin (PC); Naphtho[1,2-c:5,6-c']bis[1,2,5]thiadiazol; (2E,2'E)-3,3'(2,5-Dimethoxy-1,4-phenylen)bis(2-(5-(4-(N-(2-ethylhexyl)-1,8-naphthalimid)yl)thiophen-2-yl)acrylnitril) (NIDCS-MO); Thieno[3,4-b]thiophen- und 2-(1,1-Dicyanomethylen)rhodanin-Kombination (ATT-1); (3,9-bis(4-(1,1-Dicyanomethylen)-3-methylen-2-oxo-cyclopenta[b]thiophen)-5,5,11,11-tetrakis(4-hexylphenyl)-dithieno[2,3-d':2,3-d']-s-Indaceno[1,2-b:5,6-b']-dithiophen (ITCC}; Indandandion; Oicyannovinyl; Benzothiadiazol; und Diketopyrolopyrrol.

4. Aktive Schicht nach einem der Ansprüche 1 oder 2, wobei das Nicht-Fulleren-Material Arylendiimid beinhaltet.

5. Aktive Schicht nach einem der Ansprüche 1-4, wobei die aktive Schicht im Wesentlichen aus der einen oder mehreren Nicht-Fulleren-Komponenten und der einen oder mehreren Loch-Scavenger-Komponenten besteht.

6. Aktive Schicht nach einem der Ansprüche 1-4, wobei die aktive Schicht aus einer oder mehreren Nicht-Fulleren-Komponenten und einer oder mehreren Loch-Scavenger-Komponenten besteht.

7. Optoelektronische Vorrichtung, umfassend

ein erstes Elektrodenmaterial;
eine aktive Schicht nach einem der Ansprüche 1-7; und
ein zweites Elektrodenmaterial;
wobei das erste Elektrodenmaterial und das zweite Elektrodenmaterial auf gegenüberliegenden Seiten der aktiven Schicht sind.

8. Optoelektronische Vorrichtung nach Anspruch 7, wobei die optoelektronische Vorrichtung eines oder mehrere von einer organischen Fotovoltaik, organischen Fotodiode, organischen lichtemittierenden Diode, organischem Foto-Feldeffekttransistor, Fotodetektor und Paraelektrikum ist.

9. Tandem-Solarzelle, umfassend:

ein Substrat;
eine erste Unterzelle, die mindestens eine aktive Schicht nach einem der Ansprüche 1-7 beinhaltet; und
eine zweite Unterzelle, ausgewählt aus amorphem Silizium, Perowskit-Kristallstrukturen, farbstoffsensibilier-ten Festkörperstrukturen, farbstoffsensibilisierten Flüssigelektrolytstrukturen, Cadium-Tellurid-Materialien, Cadmiumsulfid-Materialien und Galliumarsenid-Materialien;
wobei die erste Unterzelle und das Substrat auf gegenüberliegenden Seiten der zweiten Unterzelle sind.

10. Solarzelle nach Anspruch 9, wobei die erste Unterzelle zumindest einen Teil des Lichts im nahen Infrarotbereich des elektromagnetischen Spektrums absorbiert.

11. Solarzelle nach einem der Ansprüche 9 oder 10, wobei die zweite Unterzelle zumindest einen Teil des Lichts im sichtbaren Bereich des elektromagnetischen Spektrums absorbiert.

**Revendications**

1. Couche active d'un dispositif optoélectronique, la couche active comprenant :

    un ou plusieurs matériaux non fullerènes ; et
    un ou plusieurs matériaux piégeurs de trous ;
    dans laquelle les un ou plusieurs matériaux non fullerènes sont intimement mélangés avec les un ou plusieurs matériaux piégeurs de trous, et dans laquelle un rapport des un ou plusieurs composants piégeurs de trous aux un ou plusieurs composants non fullerènes dans la couche active varie de 1:10 à 1:25, et la couche active ayant une transmission moyenne dans le visible supérieure à 70 %,
    dans laquelle les un ou plusieurs matériaux piégeurs de trous comprennent l'un ou plusieurs parmi le thiophène, l'acène, le fluor, le carbazole, l'indacénodithiénothiophène, l'indacénothiénothiphène, le benzodithiazole, la thiény-benzodithiophène-dione, le benzotriazole et le dicétopyrrolopyrrole.

2. Couche active selon la revendication 1, dans laquelle les un ou plusieurs composants piégeurs de trous comprennent un premier matériau piégeur de trous et un deuxième matériau piégeur de trous, le premier matériau piégeur de trous et le deuxième matériau piégeur de trous étant différents.

3. Couche active selon l'une quelconque des revendications 1 et 2, dans laquelle le matériau non fullerène comprend l'un ou plusieurs parmi l'indacénodithiophène couplé à rhodanine-benzothiadiazole (IDTBR) ; l'indacénodithiéno[3,2-b]thiophène (IT), à coiffe terminal de groupes 2-(3-oxo-2,3-dihydroindène-1-ylidène)malononitrile (INCN) (ITIC) ; l'indacéno[1,2-b:5,6-b']dithiophène et le 2-(3-oxo-2,3-dihydroindène-1-ylidène)malononitrile (IEIC) ; le 2,2'-((2Z,2'Z)-((5,5'-(4,4,9,9-tétrakis(4-hexylphényl)-4,9-dihydro-s-indaceno[1,2-b:5,6-b']dithiophène-2,7-diyl)bis(4-((2-éthylhexyl)-oxy)thiophène-5,2-diyl))bis(méthanylylidène))bis(3-oxo-2,3-di-hydro-1H-indène-2,1-diylidène))dimalononitrile (IEICO) ; le naphtalènediimide (NDI) ; le pérylènebisimide lié en position bay (di-PBI) ; le pérylènebisimide (PBI) ; la naphtalocyanine (NC) ; la phtalocyanine (PC) ; le naphto[1,2-c:5,6-c']bis[1,2,5]thiadiazole ; le (2E,2'E)-3,3'-(2,5-diméthoxy-1,4-phénylène)bis(2-(5-(4-(N-(2-éthylhexyl)-1,8-naphtalimide)yl)thiophén-2-yl)acrylonitrile) (NIDCS-MO) ; une combinaison de thiéno[3,4-b]thiophène et de 2-(1,1-dicyanométhylène)rhodanine (ATT-1) ; le (3,9-bis(4-(1,1-dicyanométhylène)-3-méthylène-2-oxo-cyclopenta[b]thiophène)-5,5,11,11-tétrakis(4-hexylphényl)-dithiéno[2,3-d':2,3-d']-s-indacéno[1,2-b:5,6-b']-dithiophène (ITCC) ; l'indanedione ; le dicyanovinyle ; le benzothiadiazole ; et le dicétopyrolopyrrole.

4. Couche active selon l'une quelconque des revendications 1 ou 2, dans laquelle le matériau non fullerène comprend un arylènediimide.

5. Couche active selon l'une quelconque des revendications 1 à 4, la couche active étant constituée essentiellement des un ou plusieurs composants non fullerènes et des un ou plusieurs composants piégeurs de trous.

6. Couche active selon l'une quelconque des revendications 1 à 4, la couche active étant constituée des un ou plusieurs composants non fullerènes et des un ou plusieurs composants piégeurs de trous.

7. Dispositif électronique, comprenant :

    un premier matériau d'électrode ;
    une couche active selon l'une quelconque des revendications 1- 7 ; et
    un deuxième matériau d'électrode ;
    dans lequel le premier matériau d'électrode et le deuxième matériau d'électrode sont sur des côtés opposés de la couche active.

8. Dispositif optoélectronique selon la revendication 7, le dispositif optoélectronique étant l'un ou plusieurs parmi un photovoltaïque organique, une photodiode organique, une diode électroluminescente organique, un phototransistor à effet de champ organique, un photodétecteur et un paraélectrique.

9. Une cellule solaire en tandem, comprenant :

    un substrat ;
    une première sous-cellule comprenant au moins une couche active selon l'une quelconque des revendications 1 à 7 ; et

une deuxième sous-cellule choisie parmi du silicium amorphe, des structures cristallines de pérovskite, des structures sensibilisées par colorant à l'état solide, des structures sensibilisées par colorant à électrolyte liquide, des matériaux à base de tellurure de cadmium, des matériaux à base de sulfure de cadmium et des matériaux à base d'arséniure de gallium ;
dans laquelle la première sous-cellule et le substrat sont sur des côtés opposés de la deuxième sous-cellule.

10. Cellule solaire selon la revendication 9, dans laquelle la première sous-cellule absorbe au moins une partie de la lumière dans la région proche infrarouge du spectre électromagnétique.

11. Cellule solaire selon l'une quelconque des revendications 9 ou 10, dans laquelle la deuxième sous-cellule absorbe au moins une partie de la lumière dans la région visible du spectre électromagnétique.

100

101 CONTACTING ONE OR MORE OF A NON-FULLERENE COMPONENT AND A HOLE-SCAVENGING COMPONENT TO FORM A BLENDED SOLUTION

102 DEPOSITING THE BLENDED SOLUTION

# FIG. 1

200

| 203 |
|-----|
| 207 |
| 211 |

# FIG. 2

300

| |
|---|
| <u>301</u><br>(OPTIONAL) |
| <u>303</u> |
| <u>305</u><br>(OPTIONAL) |
| <u>307</u> |
| <u>309</u><br>(OPTIONAL) |
| <u>311</u> |

# FIG. 3

400

401 DEPOSITING A BLENDED SOLUTION ON A FIRST MATERIAL SUFFICIENT TO FORM AN ACTIVE LAYER

402 DEPOSITING A SECOND MATERIAL ON THE ACTIVE LAYER

## FIG. 4

500

| 501 | IRRADIATING AN ACTIVE LAYER OF AN OPTOELECTRONIC DEVICE |

| 502 | CONVERTING LIGHT TO ELECTRICITY OR ELECTRICIY TO LIGHT |

## FIG. 5

| Glass |
| ITO |
| ZnO |
| Active layer |
| MoOx |
| Ag |

**FIG. 6**

PTB7-th

IEICO-4F

R₁=2-ethylhexyl

R=2-ethylhexyl

## FIG. 7

EP 3 729 533 B1

**FIG. 8**

FIG. 9

**FIG. 10**

**FIG. 11**

**FIG. 12**

FIG. 13

FIG. 14B

FIG. 14A

| | $V_{OC}$ (mV) | $J_{SC}$ (mA cm$^{-2}$) | FF | PCE (%) |
|---|---|---|---|---|
| Diluted organic system (single junction) | 720 | 12.6 | 0.66 | 6.1 |
| Amorphous silicon (single junction) | 920 | 11.9 | 0.70 | 7.7 |
| A-Si + diluted organic system (tandem) | 1602 | 11.5 | 0.76 | 14.0 |

FIG. 15

| | Ag |
|---|---|
| **OPV subcell** | Bathocuproine (BCP) |
| | Diluted organic bulk heterojunction |
| | PEDOT:PSS |
| | ITO |
| **a-Si subcell** | a-Si:H – negatively doped |
| | a-Si:H – undoped |
| | a-Si:H – positively doped |
| | Aluminium-doped zinc oxide (AZO) |
| | Glass |

Light

# FIG. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Design, Synthesis, and Photovoltaic Characterization of a Small Molecular Acceptor with an Ultra-Narrow Band Gap. **HUIFENG YAO et al.** ANGEWANDTE CHEMIE. 01 February 2017, vol. 56, 3045-3049